(19) **Europäisches Patentamt**
**European Patent Office**
**Office européen des brevets**

(11) **EP 4 386 873 B1**

(12) **FASCICULE DE BREVET EUROPEEN**

(45) Date de publication et mention de la délivrance du brevet:
**11.06.2025  Bulletin 2025/24**

(21) Numéro de dépôt: **23215188.6**

(22) Date de dépôt: **08.12.2023**

(51) Classification Internationale des Brevets (IPC):
**H10F 30/26** (2025.01)

(52) Classification Coopérative des Brevets (CPC):
**H10F 30/26;** G01S 7/4863

(54) **DÉMODULATEUR PHOTONIQUE ASSISTÉ PAR COURANT COMPORTANT DES RÉGIONS DOPÉES DE MODULATION ET DE COLLECTION AGENCÉES VERTICALEMENT ET SITUÉES DANS UNE ZONE EN COMPRESSION**

STROMUNTERSTÜTZTER PHOTONISCHER DEMODULATOR MIT VERTIKAL ANGEORDNETEN DOTIERTEN MODULATIONS- UND SAMMELREGIONEN IN EINER ZONE UNTER DRUCKBEANSPRUCHUNG

CURRENT-ASSISTED PHOTONIC DEMODULATOR COMPRISING DOPED MODULATION AND COLLECTION REGIONS ARRANGED VERTICALLY AND LOCATED IN A ZONE UNDER COMPRESSION

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **12.12.2022  FR 2213208**

(43) Date de publication de la demande:
**19.06.2024  Bulletin 2024/25**

(73) Titulaire: **Commissariat à l'Energie Atomique et aux Energies Alternatives
75015 Paris (FR)**

(72) Inventeurs:
• **ALIANE, Abdelkader
38054 Grenoble cedex 09 (FR)**
• **KAYA, Hacile
38054 Grenoble cedex 09 (FR)**

(74) Mandataire: **Brevalex
22 Avenue Doyen Louis Weil
38000 Grenoble (FR)**

(56) Documents cités:
**WO-A1-2022/123985     FR-A1- 3 080 489
US-B2- 11 508 870**

• **GIAN-FRANCO DALLA BETTA ET AL: "Design and Characterization of Current-Assisted Photonic Demodulators in 0.18- $\mu\hbox{m}$ CMOS Technology", IEEE TRANSACTIONS ON ELECTRON DEVICES, IEEE, USA, vol. 58, no. 6, 1 June 2011 (2011-06-01), pages 1702 - 1709, XP011323216, ISSN: 0018-9383, DOI: 10.1109/ TED.2011.2126578**

**Description**

**DOMAINE TECHNIQUE**

Le domaine de l'invention est celui des démodulateurs photoniques assistés par courant (CAPD pour *Current-Assisted Photonic Demodulator,* en anglais) adaptés à détecter un rayonnement lumineux dans le proche infrarouge. L'invention trouve une application notamment dans la télémétrie, l'analyse biologique, et l'inspection industrielle (détection sans contact de défauts surfaciques).

**ÉTAT DE LA TECHNIQUE ANTÉRIEURE**

Les démodulateurs photoniques assistés par courant sont des photodétecteurs dans lesquels la distribution d'un champ électrique de dérive est modulée. Ils ont été décrits initialement notamment dans l'article scientifique de Van Nieuwenhove et al. intitulé Novel Standard CMOS Detector using Majority Current for giding Photo-Generated Electrons towards Detecting Junctions, Proc. Symp. IEEE/LEOS Benelux Chapter, pp. 229-232, 2005. Ce type de dispositif optoélectronique est particulièrement utilisé dans la télémétrie par mesure du temps de vol (TOF, pour *Time of Flight* en anglais).

Un tel démodulateur comporte habituellement une portion de détection réalisée à base d'un matériau semiconducteur cristallin légèrement dopé de type p, qui présente, au niveau de l'une de ses faces, deux régions dopées p+ pour la génération et la modulation d'un courant de dérive, ainsi que deux régions dopées n+ situées à proximité des régions dopées p+ pour la collection du photocourant. Une différence de potentiel électrique est appliquée entre les régions dopées p+, ce qui génère un champ électrique de dérive dans la portion de détection. Aussi, lorsque le rayonnement lumineux est absorbé dans la portion de détection, une paire électron-trou est générée, puis le trou photogénéré se propage sous l'effet du champ de dérive en direction de la région dopée p+ ayant le plus faible potentiel électrique, alors que l'électron photogénéré est dirigé en direction de la région dopée p+ opposée, puis est collecté par la région dopée n+ adjacente. Ainsi, le photocourant (électrons minoritaires) peut être mesuré efficacement par le démodulateur.

Du fait de la séparation entre le courant des trous majoritaires et le photocourant (électrons minoritaires), on limite ainsi la contribution du courant des trous majoritaires au bruit Schottky (*shot noise* en anglais) ainsi qu'au bruit thermique (*thermal noise* en anglais). Cependant, il existe un besoin de disposer d'un tel démodulateur photonique assisté par courant, adapté à détecter dans le proche infrarouge, tout en présentant de bonnes performances.

Le document WO2022/123985 A1 présente un exemple de démodulateur photonique assisté par courant selon l'état de la technique.

**EXPOSÉ DE L'INVENTION**

L'invention a pour objectif de proposer un démodulateur photonique assisté par courant, adapté à détecter dans le proche infrarouge avec une longueur d'onde de coupure supérieure à $1.55\mu$m, et présentant un courant d'obscurité réduit. Un tel démodulateur peut alors présenter de bonnes performances, notamment en termes de contraste de démodulation en AC et de bande passante.

Pour cela, l'objet de l'invention est un démodulateur photonique assisté par courant, adapté à détecter un rayonnement lumineux d'intérêt, comportant :

- une portion de détection, présentant une première face et une deuxième face opposées l'une à l'autre et parallèles à un plan principal, et comportant une zone centrale de détection du rayonnement lumineux incident. La portion de détection est réalisée en un premier matériau semiconducteur cristallin à base de germanium, et comporte des régions dopées, dont : au moins deux régions dopées de modulation, dopées de type p, et destinées à générer et à moduler un courant de dérive dans la portion de détection ; et au moins une région dopée de collection, dopée de type n, et destinée à collecter les porteurs de charge minoritaires photogénérés lors de l'absorption du rayonnement lumineux d'intérêt ;
- une couche diélectrique de passivation, réalisée à base d'un matériau électriquement isolant, et recouvrant la première face ; et des électrodes, situées au niveau de la première face et traversant la couche diélectrique de passivation, dont des électrodes de modulation en contact électrique avec les régions dopées de modulation ; et au moins une électrode de collection en contact électrique avec au moins la région dopée de collection.

Selon l'invention, le démodulateur photonique comporte une portion latérale périphérique, entourant la portion de détection dans le plan principal, réalisée à base d'un deuxième matériau présentant un coefficient de dilatation thermique inférieur à celui du premier matériau, la portion de détection présentant alors des contraintes mécaniques en tension dans le plan principal et des contraintes mécaniques en compression suivant un axe vertical orthogonal au plan principal.

De plus, lesdites régions dopées sont disposées selon un agencement vertical tel que : au moins une région dopée selon un premier type de conductivité, dite région dopée supérieure, affleure la première face et est située à proximité de la zone centrale ; et au moins deux régions dopées selon un deuxième type de conductivité opposé au premier type, dites régions dopées inférieures, sont situées à distance suivant l'axe vertical de la région dopée supérieure.

On comprend que les régions dopées inférieures sont situées du côté de la deuxième face alors que la région dopée supérieure affleure la première face. De préférence, les régions dopées inférieures sont plus proches de la deuxième face que de la première face. Les régions dopées inférieures sont séparées de la région dopée supérieure par la région intermédiaire, laquelle est non intentionnellement dopée ou légèrement dopée, et forme la région principale d'absorption du rayonnement lumineux à détecter.

Certains aspects préférés mais non limitatifs de ce démodulateur photonique sont les suivants.

Chaque région dopée inférieure peut s'étendre parallèlement au plan principal en direction de la zone centrale et de la région dopée supérieure, et présente une extrémité distale éloignée de la zone centrale et une extrémité proximale orientée vers la zone centrale.

Le démodulateur peut comporter des vias conducteurs s'étendant suivant l'axe vertical de la première face et en contact électrique avec les régions dopées inférieures.

Les vias conducteurs peuvent être distincts de la portion latérale périphérique.

En variante, les vias conducteurs peuvent être des parties, distinctes entre elles, de la portion latérale périphérique, celle-ci étant alors réalisée en un matériau électriquement conducteur.

Le ou les électrodes au contact de la ou des régions dopées supérieures peuvent être plus proches de la zone centrale, dans le plan principal, que les électrodes au contact des vias conducteurs.

Le démodulateur peut comporter deux régions dopées inférieures de modulation, et peut comporter une seule région dopée supérieure de collection, située dans la zone centrale et à distance, dans le plan principal, des régions dopées inférieures de modulation.

Le démodulateur peut comporter deux régions dopées supérieures, chacune étant située à la perpendiculaire de l'une des régions dopées inférieures.

Pour une région dopée supérieure et une région dopée inférieure verticalement adjacente, une distance verticale, suivant l'axe vertical, entre lesdites régions dopées peut être inférieure à une distance horizontale, dans le plan principal, entre l'électrode connectée à la région dopée supérieure et l'électrode connectée au via conducteur de la région dopée inférieure adjacente.

La ou les régions dopées supérieures peuvent être des régions de collection, et les régions dopées inférieures peuvent alors être des régions de modulation.

La portion latérale périphérique peut être réalisée à base de silicium. La portion de détection peut alors comporter une zone latérale réalisée à base de SiGe, située à l'interface avec la portion latérale périphérique.

L'invention porte également sur un procédé de fabrication d'un démodulateur photonique selon l'une quelconque des caractéristiques précédentes, comportant les étapes suivantes :

- réalisation, par épitaxie à partir d'un couche support, d'une première couche à base de germanium dopé ;
- réalisation des régions dopées inférieures par gravure localisée de la première couche à base de germanium dopé ;
- réalisation par épitaxie d'une couche principale à base de germanium non intentionnellement dopé, sur et au contact des régions dopées inférieures ;
- réalisation d'une tranchée au travers de la couche principale entourant la portion de détection ;
- réalisation de la portion latérale périphérique dans la tranchée, à une température supérieure à la température ambiante, de sorte que, après retour à la température ambiante, la portion de détection est en tension dans le plan principal et en compression suivant l'axe vertical ;
- réalisation d'une ou des régions dopées supérieures dans la portion de détection ;
- dépôt d'une couche diélectrique de passivation sur la portion de détection ;
- réalisation des électrodes de modulation et des électrodes de collection.

Le procédé peut comporter, avant la réalisation de la tranchée, une étape de réalisation de deux premières échancrures débouchant sur les régions dopées inférieures, suivie d'une étape de réalisation de vias conducteurs dans les premières échancrures.

Le procédé peut être tel que, lors de la réalisation de la tranchée, celle-ci débouche sur les régions dopées inférieures, de sorte que la portion latérale périphérique est alors au contact de celles-ci.

La ou les régions dopées supérieures peuvent être réalisées par implantation ionique localisée.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1A et la figure 1B sont des vues schématiques et partielles, en coupe transversale (fig.1A) et en vue de dessus (fig.1B), d'un démodulateur photonique assisté par courant selon un mode de réalisation ;

La figure 1C illustre une évolution des taux d'absorption, de transmission et de réflexion de la portion de détection, en fonction de son épaisseur ;

la figure 2A est une vue schématique et partielle, en coupe transversale, d'un démodulateur photonique assisté par courant selon une variante de réalisation ;

la figure 2B et la figure 2C sont des vues schématiques et partielles, en coupe transversale (fig.2B) et en vue de dessus (fig.2C), d'un démodulateur photonique assisté par courant selon une autre variante de réalisation ;

les figures 3A à 3L illustrent différentes étapes d'un procédé de fabrication d'un démodulateur similaire à celui de la fig.1A.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un démodulateur photonique assisté par courant, adapté à détecter un rayonnement lumineux dans la bande spectrale du proche infrarouge (SWIR) correspondant à la gamme spectrale allant de $0.8\mu m$ à $1.7\mu m$ environ, voire à $2.5\mu m$ environ. Par ailleurs, il appartient de préférence à un photodétecteur matriciel comportant une matrice de pixels de détection identiques les uns aux autres, où chaque pixel de détection comporte un démodulateur planaire.

D'une manière générale, le démodulateur comporte :

◦ une portion de détection, réalisée à base de germanium, dont une zone dite centrale est le lieu principal d'absorption du rayonnement lumineux à détecter. Elle s'étend verticalement entre une face supérieure F1 et une face inférieure F2, et horizontalement dans le plan principal XY. Elle comporte : au moins deux régions de modulation, dopées de type p, et adaptées à générer et à moduler le courant de dérive ; et au moins une région de collection, dopée de type n, et adaptées à collecter les porteurs minoritaires photogénérés ;
◦ une couche diélectrique de passivation, réalisée en au moins un matériau électriquement isolant, qui recouvre la face supérieure F1 ;
◦ des électrodes situées au niveau de la face supérieure F1 et traversant la couche diélectrique de passivation, dont des électrodes de modulation M1, M2 en contact électrique avec les régions dopées de modulation ; et au moins une électrode de collection C1, C2 en contact électrique avec la ou les régions dopées de collection.

Selon l'invention, comme détaillé par la suite, la portion de détection à base de germanium présente des contraintes mécaniques en tension dans le plan principal XY, et des contraintes mécaniques en compression orientées suivant l'axe vertical Z. Ces contraintes en tension horizontale du germanium de la portion de détection permettent au démodulateur de détecter dans la bande spectrale du proche infrarouge jusqu'à une longueur d'onde de coupure supérieure à $1.55\mu m$ (valeur de la longueur d'onde de coupure du germanium relaxé). De plus, par effet Poisson, la portion de détection subit une compression verticale.

Pour générer ces contraintes mécaniques, le démodulateur comporte une portion latérale périphérique, réalisée à base d'un matériau dont le coefficient de dilatation thermique est inférieur à celui du matériau de la portion de détection, et qui entoure la portion de détection dans le plan XY. Ainsi, à la suite de la réalisation de la portion latérale périphérique, les contraintes mécaniques sont générées dans la portion de détection.

De plus, la compression verticale de la portion de détection est mise à profit pour améliorer les performances du démodulateur. Pour cela, au lieu de disposer la ou les régions dopées de collection de manière coplanaire aux régions dopées de modulation, comme dans l'art antérieur, celles-ci sont agencées suivant une configuration verticale, tout en gardant une polarisation électrique à partir de la même face supérieure F1. Plus précisément, les régions dopées sont agencées de la manière suivante :

◦ au moins une région dopée affleure la face supérieure F1 et est située à proximité de la zone centrale. Elle est alors appelée 'région dopée supérieure'. La ou les régions dopées supérieures sont dopées selon un premier type de conductivité ;
◦ au moins deux régions dopées sont situées à distance suivant l'axe vertical Z de la ou des régions dopées supérieures. Elles sont alors appelées 'régions dopées inférieures'. Ainsi, la ou les régions dopées supérieures sont situées au-dessus suivant l'axe vertical Z des régions dopées inférieures. Elles sont dopées selon un deuxième type de conductivité opposé au premier type. Les régions dopées inférieures sont en contact électrique avec les électrodes correspondantes au moyen de vias conducteurs, lesquels peuvent être, soit distincts de la portion latérale périphérique, soit des parties de la portion latérale périphérique.

Ainsi, cet agencement vertical des régions dopées de collection et de modulation, au sein d'une portion de détection en compression verticale, permet notamment de réduire le courant d'obscurité entre la ou les régions dopées de collection et les régions dopées de modulation, du fait d'une augmentation de l'énergie de bande interdite indirecte de la portion de détection, améliorant ainsi les performances du démodulateur. De plus, il est possible de réduire la distance (verticale) entre la ou les régions dopées de collection et les régions dopées de modulation, ce qui contribue à améliorer ainsi le contraste de démodulation en AC ainsi que la bande passante. Dans le cas d'un photodétecteur matriciel, il est alors possible de réduire le pas pixel, améliorant ainsi la résolution du photodétecteur matriciel.

D'une manière générale, la ou les régions dopées de collection peuvent être les régions dopées supérieures, et les régions dopées de modulation sont alors les régions dopées inférieures. La configuration inversée est possible, où les régions dopées de collection sont les régions dopées inférieures, et les régions dopées de modulation sont les régions dopées supérieures.

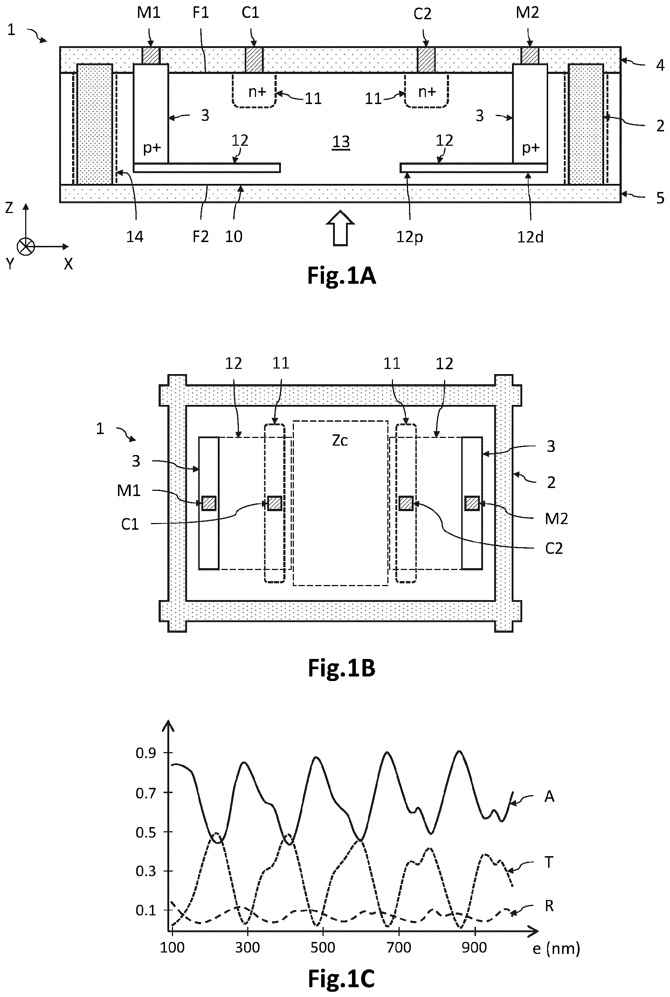

Les figures 1A et 1B sont des vues schématiques et partielles, en coupe transversale (fig.1A) et en vue de dessus (fig.1B), d'un démodulateur photonique 1 assisté par courant selon un mode de réalisation, appartenant ici à une matrice de démodulateurs 1 planaires identiques.

Dans cet exemple, la portion de détection 10 comporte deux régions dopées supérieures 11 qui sont ici des régions dopées n+ de collection, et deux régions dopées inférieures 12 qui sont alors des régions dopées p+ de modulation. Par ailleurs, les régions dopées de modulation sont connectées aux électrodes de modulation M1 et M2 par des vias conducteurs 3 dédiés (donc distincts de la portion latérale périphérique 2) et réalisés à base de germanium. Par ailleurs, la face inférieure F2 est celle qui reçoit ici le rayonnement lumineux à détecter.

On définit ici et pour la suite de la description un repère direct tridimensionnel XYZ, où les axes X et Y sont parallèles au plan principal des démodulateurs 1, et où la direction verticale +Z est orientée suivant l'épaisseur de la portion de détection 10 du démodulateur 1, à partir de la face inférieure F2 en direction de la face supérieure F1. Les termes « inférieur » et « supérieur » font référence à un positionnement croissant suivant la direction +Z définie sur la fig.1A. Par ailleurs, le terme « horizontal » fait référence à une orientation parallèle au plan XY et le terme « vertical » fait référence à une orientation parallèle à l'axe Z.

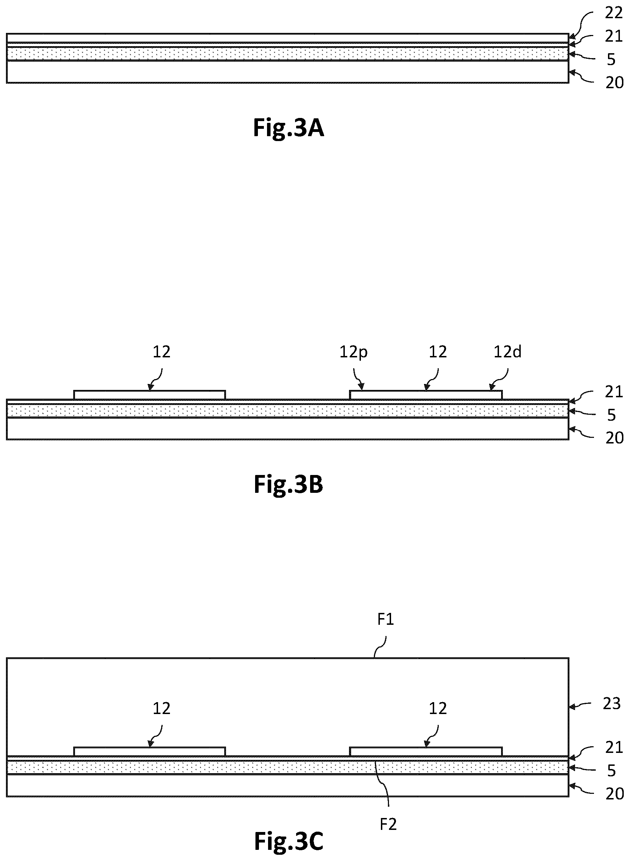

Dans cet exemple, les démodulateurs 1 présentent une configuration planaire dans la mesure où ils sont réalisés ici à partir d'une même couche semiconductrice principale 23 (cf. fig.3C). Cette dernière s'étend dans un plan principal XY entre les faces supérieure F1 et inférieure F2 opposées l'une à l'autre et parallèles au plan principal. Les deux faces F1, F2 s'étendent donc suivant des plans identiques pour chacun des démodulateurs 1, et délimitent verticalement (suivant l'axe d'épaisseur Z) les portions de détection 10 des démodulateurs 1. Aussi, les démodulateurs 1 ne présentent pas une structure en mesa dans la mesure où ils sont réalisés à partir de la même couche semiconductrice principale 23.

Chaque démodulateur 1 comporte une portion de détection 10 réalisée à base de germanium et donc adaptée à détecter le rayonnement lumineux dans le proche infrarouge (SWIR). Dans la mesure où la portion de détection 10 est réalisée à base de germanium et subit des contraintes mécaniques en tension dans le plan XY, le démodulateur 1 est adapté à détecter un rayonnement lumineux à une longueur d'onde de coupure supérieure à 1.55μm.

L'épaisseur de la portion de détection 10, définie suivant l'axe vertical Z entre les faces supérieure F1 et inférieure F2, est ici sensiblement constante d'un démodulateur 1 à l'autre, par exemple est comprise entre quelques centaines de nanomètres et quelques microns, par exemple entre 1μm et 5μm environ. L'épaisseur est choisie de manière à obtenir une bonne absorption dans la gamme de longueurs d'onde du rayonnement lumineux à détecter. La portion de détection 10 présente une dimension transversale dans le plan XY pouvant être comprise entre quelques centaines de nanomètres et quelques dizaines de microns, par exemple comprise entre 1μm et 20μm environ, par exemple égale à 10μm.

La portion de détection 10 est réalisée à base de germanium, c'est-à-dire que le ou les matériaux semiconducteurs sont du germanium ou un composé (binaire ou ternaire...) formé d'au moins le germanium. Ainsi, la portion de détection 10 peut être réalisée, par exemple, en germanium Ge, en silicium germanium SiGe, en germanium étain GeSn, voire en silicium germanium étain SiGeSn. Elle peut ainsi être réalisée en le même matériau semiconducteur et présenter des régions de différents types de conductivité (homojonction) de manière à former une jonction pn ou pin. Elle peut en variante être un empilement de sous-couches de différents matériaux semiconducteurs (hétérojonction), lesquels sont alors formés à base de germanium.

La portion de détection 10 comporte une région intermédiaire 13, non intentionnellement dopée (avec un éventuel dopage résiduel de type p) ou légèrement dopée p. La région intermédiaire 13 s'étend entre les faces F1 et F2, ainsi que dans le plan XY, et forme la région principale d'absorption du rayonnement lumineux à détecter.

On définit une zone centrale Zc de la région de détection 10 comme étant le lieu principal d'absorption du rayonnement lumineux à détecter. Cette zone centrale Zc est avantageusement délimitée dans le plan XY par un cache optique située du côté de la face F1 ou F2 qui reçoit le rayonnement lumineux à détecter. De préférence, le rayonnement lumineux à détecter est incident du côté de la face inférieure F2 (dite face avant), les régions dopées inférieures 12 peuvent alors former ce cache optique et ainsi participer à définir la fenêtre optique du démodulateur 1, en particulier lorsqu'elles sont dopées de type p au bore (modulation), comme expliqué plus bas.

Les régions dopées supérieures 11 sont donc ici des régions dopées de type n, de préférence dopées n+. Elles sont adaptées à collecter les porteurs minoritaires photogénérés (photocourant) issus de l'absorption du rayonnement lumineux à détecter dans la zone centrale Zc de la portion de détection 10 (dans la région intermédiaire 13), via le potentiel électrique qui leur est imposé par les électrodes de collection C1 et C2. Elles sont ici dopées n+, et peuvent présenter un dopage pouvant être compris entre $5\times10^{18}$ et $2\times10^{20}$ at/cm$^3$ environ.

Les régions dopées supérieures 11 affleurent la face supérieure F1 et sont situées à proximité de la zone centrale Zc. Par affleurer, on entend « arriver au niveau de », ou « s'étend à partir de ». Elles s'étendent suivant l'axe vertical Z sur une profondeur prédéfinie. Aussi, chaque région dopée supérieure 11 est ici entourée dans le plan XY et suivant la direction -Z par la région intermédiaire 13. Elle débouche directement sur la face supérieure F1, sans être espacée de celle-ci par une zone de la région intermédiaire 13.

Les deux régions dopées supérieures 11 sont disposées dans le plan XY de part et d'autre de la zone centrale Zc, et à proximité de celle-ci. Ainsi, les électrodes de collection C1 et C2 sont situées à proximité de la zone centrale Zc, alors que les électrodes de modulation M1 et M2 en sont éloignées. Plus généralement, les électrodes des régions dopées supérieures 11 sont situées à proximité de la zone centrale Zc, alors que les électrodes des régions dopées inférieures 12 sont éloignées de la zone centrale Zc.

Notons que les régions dopées supérieures 11 sont ici réalisées par implantation ionique localisée dans la portion de détection 10 à partir de la face supérieure F1. En variante, elles peuvent être réalisées par dopage à la croissance lors d'une reprise d'épitaxie dans des échancrures formées à partir de la face supérieure F1 de la portion de détection 10.

Les régions dopées inférieures 12 sont ici des régions dopées de type p, de préférence dopées p+. Elles sont adaptées à générer et à moduler le courant de dérive via le potentiel électrique qui leur est imposé par les électrodes de modulation M1 et M2. Elles sont ici dopées p+, et présentent par exemple un dopage compris entre $10^{18}$ et $10^{20}$ at/cm$^3$ environ, de préférence de $10^{19}$ at/cm$^3$.

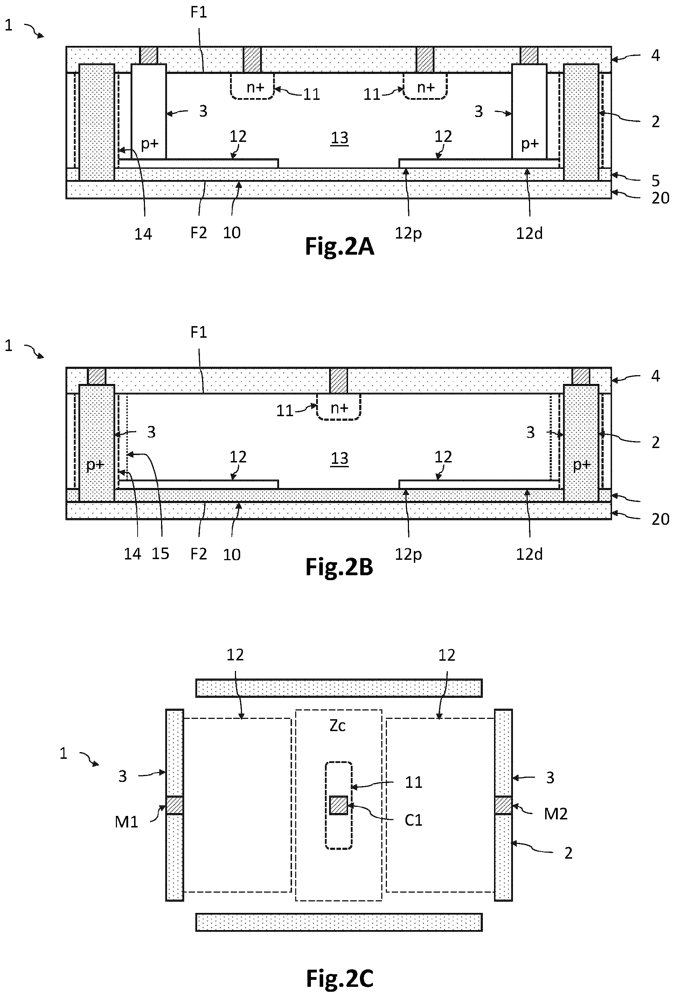

Les régions dopées inférieures 12 sont situées à distance suivant l'axe vertical Z des régions dopées supérieures 11. Autrement dit, les régions dopées supérieures 11 sont situées au-dessus suivant l'axe vertical Z des régions dopées inférieures 12 (avec ou non recouvrement de celles-ci). Les régions dopées inférieures 12 sont donc espacées des régions dopées supérieures 11 par une zone de la région intermédiaire 13 en compression verticale. Par ailleurs, les régions dopées inférieures 12 sont ici espacées de la face inférieure F2 d'une distance non nulle, mais en variante, elles pourraient affleurer la face inférieure F2 (cf. variantes des fig.2A et 2B).

Les régions dopées inférieures 12 sont situées dans le plan XY de part et d'autre de la zone centrale Zc de la portion de détection 10. Aussi, les électrodes (ici M1 et M2) des régions dopées inférieures 12 sont davantage éloignées de la zone centrale Zc que celles des régions dopées supérieures 11.

Les régions dopées inférieures 12 s'étendent parallèlement au plan XY en direction de la zone centrale Zc et des régions dopées supérieures 11, entre une extrémité distale 12d (i.e. éloignée de la zone centrale) et une extrémité proximale 12p (i.e. proche de la zone centrale). Les termes 'distale' et 'proximale' sont définis vis-à-vis de la zone centrale Zc. L'extrémité distale 12d est la zone de la connexion électrique à une électrode de modulation, ici au moyen d'un via conducteur 3 dédié, alors que l'extrémité proximale 12p est la zone principale de génération du courant de dérive.

Dans cet exemple, les régions dopées inférieures 12 s'étendent dans le plan XY en direction de la zone centrale Zc jusqu'à venir à la perpendiculaire des régions dopées supérieures 11. Autrement dit, en projection dans le plan XY, il y a recouvrement d'au moins une partie de la région dopée inférieure 12 par la région dopée supérieure adjacente 11. En variante, comme l'illustre la fig.2B, les régions dopées inférieures 12 peuvent ne pas être à la perpendiculaire des régions dopées supérieures 11.

Notons que les régions dopées inférieures 12 sont réalisées par dopage à la croissance lors d'une reprise d'épitaxie ayant lieu lors de la réalisation de la portion de détection 10. Chaque région dopée inférieure 12 présente une même épaisseur prédéfinie suivant l'axe vertical Z, et sensiblement constante dans le plan XY, par exemple égale à quelques dizaines ou centaines de nanomètres. L'épaisseur est ici égale à 200nm environ, mais elle peut être comprise entre 100 et 500nm.

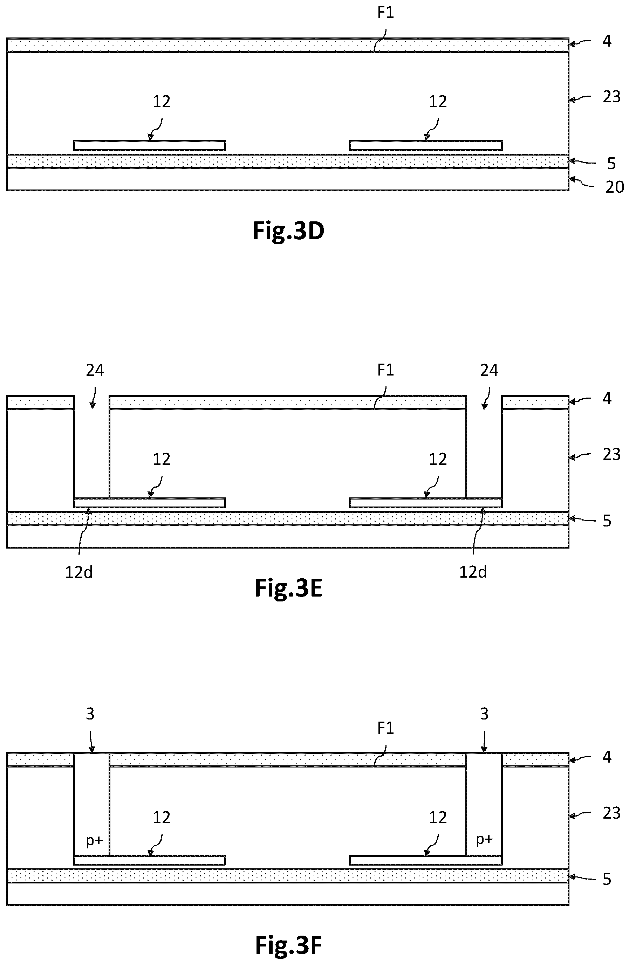

Les régions dopées inférieures 12 (ici de modulation) sont connectées électriquement aux électrodes (ici M1, M2) au moyen de vias conducteurs 3 qui s'étendent suivant l'axe vertical Z entre les électrodes concernées et l'extrémité distale 12d des régions dopées inférieures 12. Dans cet exemple, les vias conducteurs 3 sont distincts de la portion latérale périphérique 2. Ils sont réalisés en au moins un matériau électriquement conducteur, ici en un matériau à base de germanium dopé de type p, déposé dans des échancrures 24 pratiquées dans la couche semiconductrice principale 23 (cf. fig. 3F) à partir de la face supérieure F1 et débouchant sur les régions dopées inférieures 12.

La portion de détection 10 est délimitée latéralement, dans le plan XY, par une portion latérale périphérique 2, réalisée à base d'un matériau qui présente un coefficient de dilatation thermique inférieur à celui du matériau à base de germanium de la portion de détection 10. Le matériau est de préférence à base de silicium, et est de préférence du polysilicium. Il peut s'agir également de silicium monocristallin, de silicium amorphe, voire du silicium germanium. Le matériau peut éventuellement être dopé. La portion latérale périphérique 2 entoure la portion de détection 10 dans le plan XY, soit de manière continue (cf. fig.1B), soit de manière discontinue (cf. fig.2C).

Du fait du différentiel de dilatation thermique, à la suite de la réalisation de la portion latérale périphérique 2 par dépôt à une température supérieure à la température ambiante, par exemple par épitaxie à une température comprise entre 500°C et 700°C, la portion de détection 10 présente des contraintes mécaniques en tension horizontale, et par effet Poisson, des contraintes mécaniques en compression verticale.

La portion latérale périphérique 2 assure en outre une isolation optique latérale des démodulateurs 1 dans le plan XY. Elle s'étend ici de préférence sur toute l'épaisseur de la portion de détection 10 pour déboucher sur la couche support 5.

Lorsque le matériau de la portion latérale périphérique 2 est réalisé à base de silicium, une zone latérale 14 réalisée à base de silicium germanium peut être présente entre et au contact de la portion de détection 10 et la portion latérale périphérique 2. La zone latérale 14 présente une énergie de bande interdite (gap) supérieure à celle de la portion de détection 10 réalisée en germanium. Cette « ouverture de gap » latérale permet de diminuer la sensibilité du démodulateur 1 aux défauts présents à proximité de la tranchée latérale périphérique. On améliore ainsi également les performances du démodulateur 1.

Par ailleurs, la portion de détection 10 repose une couche support 5. Celle-ci peut être réalisée en un matériau cristallin semiconducteur adapté à l'épitaxie du germanium de la portion de détection 10. Ce matériau peut être dopé ou non. Cette couche support 5 peut être une couche supérieure d'un substrat SiGeOi ou d'un substrat GeOi. Elle est ici réalisée en silicium.

Dans le cas ici où les régions dopées inférieures 12 ne sont pas au contact de la couche support 5 (cf. fig.1A), le matériau de la couche support 5 peut être dopé et être porté à un potentiel électrique, par exemple via la portion latérale périphérique 2. Dans le cas contraire où les régions dopées inférieures 12 sont au contact de la couche support 5 (fig.2A), le matériau de celle-ci est non intentionnellement dopé. En variante, la portion de détection 10 peut reposer sur une couche support 5 réalisée en un matériau isolant.

Le démodulateur 1 comporte une couche diélectrique de passivation 4, réalisée en au moins un matériau électriquement non conducteur, comme un isolant ou un semiconducteur intrinsèque. Elle recouvre la face supérieure F1 et permet de passiver la portion de détection 10 et d'isoler électriquement les électrodes M1, M2, C1, C2. Elle est ainsi au contact de la région intermédiaire 13, des régions dopées supérieures 11, des vias conducteurs 3, et de la portion latérale périphérique 2. Elle est de préférence réalisée en un oxyde, tel qu'un oxyde de silicium, d'aluminium, de germanium, d'hafnium, etc... voire en silicium intrinsèque. Elle présente une épaisseur par exemple comprise entre 2nm et 500nm.

Le démodulateur 1 comporte électrodes M1, M2, C1, C2 situées du côté de la face supérieure F1, qui traversent la couche diélectrique de passivation 4 et sont raccordées électriquement aux régions dopées supérieures 11 et inférieures 12. Les électrodes de modulation M1, M2 permettent de générer et moduler le courant de dérive. Elles sont ici au contact des vias conducteurs 3, et permettent ainsi d'appliquer un potentiel électrique positif ou nul aux régions dopées inférieures 12 (ici de modulation). Elles sont connectées à un circuit électrique de commande. Les électrodes de collection C1, C2 permettent de collecter les électrons photogénérés (photocourant). Elles sont ici au contact des régions dopées supérieures 11 (ici de collection) pour leur appliquer un potentiel électrique positif. Elles sont connectées à un circuit électrique de lecture. Comme indiqué plus haut, les électrodes des régions dopées inférieures 12 sont davantage éloignées de la zone centrale Zc que les électrodes des régions dopées supérieures 11.

Le démodulateur 1 est ainsi adapté à détecter dans le proche infrarouge, avec une longueur d'onde de coupure supérieure à $1.55\mu m$. Cela est dû à la mise en tension dans le plan XY de la portion de détection 10 à base de germanium, ce qui conduit à une réduction du gap optique du matériau de la portion de détection 10. De plus, cette tension horizontale de la portion de détection 10 permet d'augmenter la mobilité des porteurs de charge, et donc améliore la bande passante du démodulateur 1.

De plus, la mise en compression verticale de la portion de détection 10 conduit à une augmentation du gap indirect du matériau à base de germanium de la portion de détection 10, et donc à une réduction du courant d'obscurité entre chaque région dopée de modulation et la région dopée de collection adjacente, lesquelles sont agencées verticalement.

Il est alors possible de réduire la distance verticale entre chaque région dopée de modulation et la région dope de collection adjacente. On améliore alors le contraste de démodulation en AC et la bande passante du démodulateur 1, tout en écartant le risque d'une augmentation du courant de fuite. Par ailleurs, il est possible de réduire le pas pixel, dans le cas d'un photodétecteur matriciel.

Dans le cas d'un éclairage en face arrière (face inférieure F2), et lorsque les régions dopées inférieures 12 sont les régions dopées p+ (germanium dopé par exemple au bore avec une concentration de l'ordre de $10^{19}$ cm$^{-3}$), ces mêmes régions dopées inférieures 12 forment un réflecteur et donc un cache optique définissant dans le plan XY la fenêtre optique et donc la zone centrale Zc. Il n'est alors pas nécessaire de réaliser un cache optique dédié.

Par ailleurs, il est avantageux d'optimiser l'épaisseur de la portion de détection 10, afin d'absorber efficacement le rayonnement lumineux infrarouge à la longueur d'onde voulue, tout en générant des contraintes mécaniques en tension et en compression suffisantes.

A ce titre, la figure 1C illustre un exemple d'évolution des taux d'absorption A, de transmission T et de réflexion R de la portion de détection 10 vis-à-vis d'un rayonnement lumineux de longueur d'onde 1.55$\mu$m.

Dans cet exemple, la couche diélectrique de passivation 4 est en SiO$_2$ de 280nm d'épaisseur, permettant ainsi d'être un bon antireflet. La portion de détection 10 est réalisée en germanium, et la région intermédiaire 13 présente un dopage de type p de l'ordre de $10^{15}$ cm$^{-3}$ environ. Les portions dopées inférieures 12 (de modulation) sont en germanium dopé au bore avec une concentration de $10^{19}$ cm$^{-3}$ environ et présentent une épaisseur de 200nm. Les portions dopées supérieures 11 (de collection) sont en germanium dopé au phosphore (ou avec de l'arsénique, ou antimoine) avec une concentration de $10^{19}$ cm$^{-3}$ environ. La portion de détection 10 présente une épaisseur (entre les deux faces F1 et F2) que l'on fait varier. Elle est entourée par une portion latérale périphérique 2 en silicium polycristallin.

Les taux d'absorption A, de transmission T et de réflexion R illustrés sur la fig.1C sont obtenus par simulation numérique des équations de l'électromagnétique à l'aide du logiciel COMSOL Multiphysics. Il apparaît que les pics d'absorption se situent pour des épaisseurs de la portion de détection 10 de 300nm, de 480nm, de 670nm, et de 860nm environ. Ainsi, pour une épaisseur de 295nm, le taux d'absorption A est égal à 85% environ. Il monte à 88% environ pour l'épaisseur de 480nm, et à 90% environ pour l'épaisseur de 670nm.

De plus, on détermine les contraintes mécaniques à l'aide du même logiciel, pour différentes valeurs d'épaisseur de la portion de détection 10. Ainsi, pour une épaisseur de 295nm, une déformation en tension horizontale de +0.36% et obtenue ainsi qu'une déformation en compression verticale de -0.14%. Pour une épaisseur de 480nm, on obtient +0.30% de tension horizontale, et -0.12% de compression verticale. Et pour une épaisseur de 670nm, on obtient +0.25% de tension horizontale, et -0.11% de compression verticale. Ainsi, les contraintes mécaniques diminuent en intensité à mesure qu'on augmente l'épaisseur de la portion de détection 10.

Aussi, dans cet exemple, une épaisseur de 480nm paraît être un bon compromis entre l'absorption optique et les déformations mécaniques. Elle permet ainsi d'obtenir un taux d'absorption (ici 88%) élevé ainsi que des contraintes mécaniques suffisantes (tension en horizontal de +0.30%, et compression en vertical de -0.12%).

Les performances d'un tel démodulateur 1 sont particulièrement élevées, que ce soit en termes de réponse impulsionnelle temporelle et de bande passante, dans la mesure où on obtient une valeur maximale de 95% pour le contraste en démodulation C$_{ac}$ en AC, et une bande passante de l'ordre de 400 à 500 MHz. Ici, les régions dopées de collection (régions supérieures 11) sont portées à une polarisation électrique de +1V, et les régions dopées de modulation (régions inférieures 12) sont portées l'une à 0V et l'autre à +0.7V. En fonctionnement, ces deux modulateurs sont en opposition de phase et modulés en fréquence.

Rappelons que la réponse impulsionnelle temporelle correspond au contraste de démodulation C$_{ac}$ en AC. Le contraste C$_{AC}$ est défini par la relation suivante (simplifiée ici à une configuration bidimensionnelle) : C$_{ac}$(f) = ( Q$_{C1}$(t)-Q$_{C2}$ (t) )/Q$_{tot}$, où Q$_{C1}$ et Q$_{C2}$ sont les charges électriques au niveau des électrodes C1 et C2, et Q$_{tot}$ est la charge totale dans le démodulateur 1. Le contraste de démodulation C$_{ac}$ en AC est un contraste qui est extrait à partir de la variation temporelle des courants récoltés par les régions dopées n+ de collection. L'intégration de ces deux courants donne les quantités de charges dans le démodulateur 1. En revanche, le contraste de démodulation C$_{dc}$ en DC ne fait pas intervenir la fréquence (contraste en statique).

Comme décrit notamment dans l'article scientifique de Dalla Betta et al. intitulé Design and Characterization of Current-Assisted Photonic Demodulators in 0.18-$\mu$m CMOS Technology, IEEE Trans. Electron Devices, vol. 58, no. 6, pp.1702-1707, June 2011, le contraste de démodulation C$_d$ est défini tel que : $C_d = f_{C1}^{ac} \times I_{tot}^{ac} / I_{tot}^{dc}$ , où I$_{tot}$ est le photocourant total collecté aux électrodes C1 et C2 : I$_{tot}$ = I$_{C1}$ + I$_{C2}$ ; et f$_{C1}$ est la fraction du photocourant I$_{tot}$ collecté par l'électrode C1. Dans le cas où le rayonnement lumineux incident est modulé de manière sinusoïdale en puissance et que la tension électrique appliquée entre les électrodes de modulation M1 et M2 est également sinusoïdale (les deux modulateurs sont toujours en opposition de phase entre eux), de même fréquence que le rayonnement lumineux, les photocourants collectés peuvent s'écrire ainsi :

$$I_{C1} = \left[\frac{1}{2} + f_{C1}^{ac} \sin(2\pi ft)\right] \times \left[I_{tot}^{dc} + I_{tot}^{ac} \sin(2\pi ft - \varphi)\right]$$

$$I_{C2} = \left[\frac{1}{2} - f_{C1}^{ac} \sin(2\pi ft)\right] \times \left[I_{tot}^{dc} + I_{tot}^{ac} \sin(2\pi ft - \varphi)\right]$$

où $I_{tot}^{dc}$ et $I_{tot}^{ac}$ sont les composantes continue et alternative du photocourant mesuré $I_{tot}$, $f_{C1}^{ac}$ est l'amplitude de la composante AC de la fraction $f_{C1}$, f est la fréquence de modulation, et $\phi$ est le déphasage entre la lumière émise et la lumière reçue. A partir de ces deux équations, on peut accéder à la moyenne des courants $I_{C1}$ et $I_{C2}$ qui contiennent directement la phase $\phi$ à partir de laquelle on peut ainsi déterminer une distance d'un objet situé dans la scène éclairée. Ces courants électriques permettent de déterminer le contraste de démodulation $C_{ac}$ en AC.

La figure 2A est une vue schématique et partielle, en coupe transversale, d'un démodulateur photonique 1 assisté par courant selon une variante de réalisation.

Dans cet exemple, le démodulateur 1 se distingue de celui de la fig.1A en ce que la portion de détection 10 a été réalisée par épitaxie à partir d'un substrat SOI. La portion de détection 10 est alors au contact d'une couche support 5 réalisée en silicium, de préférence monocristallin. Cette couche support 5 est une couche de nucléation pour le germanium de la portion de détection. Elle repose sur une couche isolante 20 en un oxyde de silicium (BOX). Une couche épaisse en silicium (non représentée) peut être présente au contact de la couche d'oxyde 20. Ici, les régions dopées inférieures 12 sont au contact de la couche support 5. Aussi, celle-ci est en silicium non intentionnellement dopée, de manière à éviter tout court-circuit entre les régions dopées inférieures.

Les figures 2B et 2C sont des vues schématiques et partielles, en coupe transversale (fig.2B) et en vue de dessus (fig.2C), d'un démodulateur photonique 1 assisté par courant selon une variante de réalisation.

Dans cet exemple, le démodulateur 1 se distingue de ceux des fig.1A et 2A notamment en ce qu'il ne comporte qu'une seule région dopée de collection, qui est alors une région dopée supérieure 11 située au centre de la zone centrale Zc. Les régions dopées de modulation sont alors des régions dopées inférieures 12.

Par ailleurs, les vias conducteurs 3 qui assurent la polarisation électrique des régions dopées inférieures 12 ne sont pas des vias distincts de la portion latérale périphérique 2, mais sont des parties (distinctes entre elles) de la portion latérale périphérique 2. Celle-ci est ici formée d'une pluralité de parties distinctes dans le plan XY (sans continuité de matière entre elles). La portion latérale périphérique 2 est réalisée en un matériau conducteur dopé du même type de conductivité que les régions dopées inférieures 12, ici de type p. Dans cet exemple, elle est réalisée en silicium polycristallin dopé p+ avec une concentration en bore de $10^{20}$ cm$^{-3}$ environ. Les électrodes sont alors au contact des parties de la portion latérale périphérique 2.

Une zone latérale 15 dopée de type p peut être présente dans la portion de détection 10, le long de la portion latérale périphérique 2, lorsque celle-ci est dopée de type p comme ici. Cette région latérale 15 dopée p+ permet d'éviter que la zone de charge d'espace du démodulateur 1 ne s'étende jusqu'à la bordure latérale de la portion de détection 10. Ainsi, on limite la contribution de cette zone (potentiellement non exempte de défauts liés à la réalisation des tranchées) au courant d'obscurité.

Les figures 3A à 3L illustrent différentes étapes d'un procédé de fabrication d'une matrice de démodulateurs photoniques 1 assistés par courant similaires à celui illustré sur la fig.1A. Les démodulateurs 1 présentent ici une configuration planaire. Ils sont réalisés à base de germanium, et sont donc adaptés à détecter un rayonnement infrarouge dans le proche infrarouge. Les portions de détection 10 sont réalisées en germanium. Dans cet exemple, ils sont réalisés à partir d'un substrat SOI de croissance.

En référence à la fig.3A, on fournit un substrat SOI de croissance, dont la couche supérieure 5 est une couche de silicium monocristallin de 10 à 100nm d'épaisseur. On réalise ensuite par épitaxie une couche 21 de germanium non intentionnellement dopé (nid) de quelques dizaines de nanomètres, par exemple 50nm. La température de croissance peut être de 400°C. Puis, on réalise par épitaxie une couche 22 de germanium dopé de type p avec une concentration de $10^{19}$ cm$^{-3}$ environ, d'une épaisseur de 200nm environ, à une température de 400°C.

En référence à la fig.3B, on réalise ensuite les régions dopées inférieures 12, par lithographie et gravure localisée de la couche 22 dopée p++, avec arrêt de gravure sur la couche inférieure 21 en germanium nid. Chaque région dopée inférieure 12 s'étend entre une extrémité proximale 12p et une extrémité distante 12e dans le plan XY. Les extrémités proximales 12p délimitent suivant l'axe X la fenêtre optique. La dimension suivant l'axe X de la fenêtre optique dépend du pas pixel, et peut ainsi aller de $1.5\mu m$ à plusieurs dizaines de microns.

En référence à la fig.3C, on réalise la couche semiconducteur principale 23 par épitaxie à partir de la couche 21 de germanium nid et des régions dopées inférieures 12. La couche semiconductrice principale 23 est en germanium non intentionnellement dopé et présente une épaisseur comprise entre 700 et 800nm environ. Elle peut être réalisée comme décrit notamment dans la publication de Hartmann & Aubin intitulé Assessment of the growth/etch back technique for the production of Ge strain-relaxed buffers on Si, Journal of Crystal Growth, 488 (2018), 43. La couche semiconductrice principale 23 présente alors une très faible densité de dislocations émergentes (par exemple de l'ordre de $10^7$ dislocations/cm$^2$), ce qui contribue à réduire le courant d'obscurité dans la portion de détection 10 du démodulateur 1.

Puis, on effectue une étape de planarisation mécano-chimique (CMP), pour planariser la face supérieure F1, et pour réduire l'épaisseur de la couche semiconducteur principale 23 à une valeur optimale ayant été déterminée (par exemple égale à 480 nm environ). L'épaisseur de ce qui sera la portion de détection est définie entre la face inférieure F2 (interface entre la couche 21 de germanium nid et la couche support 5 de nucléation) et la face supérieure F1.

En référence à la fig.3D, on dépose une couche diélectrique de passivation 4 sur la face supérieure F1 de la couche semiconductrice principale 23 (la couche 21 est intégrée à la couche 23). Cette couche diélectrique de passivation 4 peut être formée d'une première sous-couche de passivation réalisée par exemple en un oxyde d'aluminium déposé par un dépôt en couche atomique (ALD pour *Atomic Layer Deposition* en anglais) d'une épaisseur de l'ordre de 10 à 50nm, par exemple 10nm, ou même par une fine couche de silicium non intentionnellement dopé avec une épaisseur allant de 1 à 4nm, déposée par épitaxie sur le germanium de la portion de détection 10. Ensuite, une deuxième sous-couche réalisée par exemple en un oxyde de silicium tel que du $SiO_2$ TEOS (orthosilicate de tétraéthyle) d'une épaisseur de l'ordre de 100 à 500nm, est déposée sur la première sous-couche sous-jacente.

En référence à la fig.3E, on réalise ensuite des échancrures 24 dans la couche principale 23, s'étendant suivant l'axe Z à partir de la face supérieure F1 jusqu'à déboucher sur les régions dopées inférieures 12, au niveau des extrémités distales 12d. Ces échancrures 24 sont réalisées par lithographie et gravure localisée, avec arrêt de gravure sur le germanium dopé p++ des régions dopées inférieures 12. Les dimensions transversales de ces échancrures 24 peuvent être de l'ordre de 0.5 à $1\mu$m environ.

En référence à la fig.3F, on réalise ensuite les vias conducteurs 3, par dépôt d'un matériau électriquement conducteur dans les échancrures 24. Ici, on remplit les échancrures 24 par épitaxie à une température de 600°C environ par du germanium dopé de type p au bore avec une concentration de $10^{19}$ cm$^{-3}$ environ. Une étape de planarisation CMP est ensuite effectuée pour éliminer le germanium dopé p+ reposant sur la couche diélectrique de passivation 4.

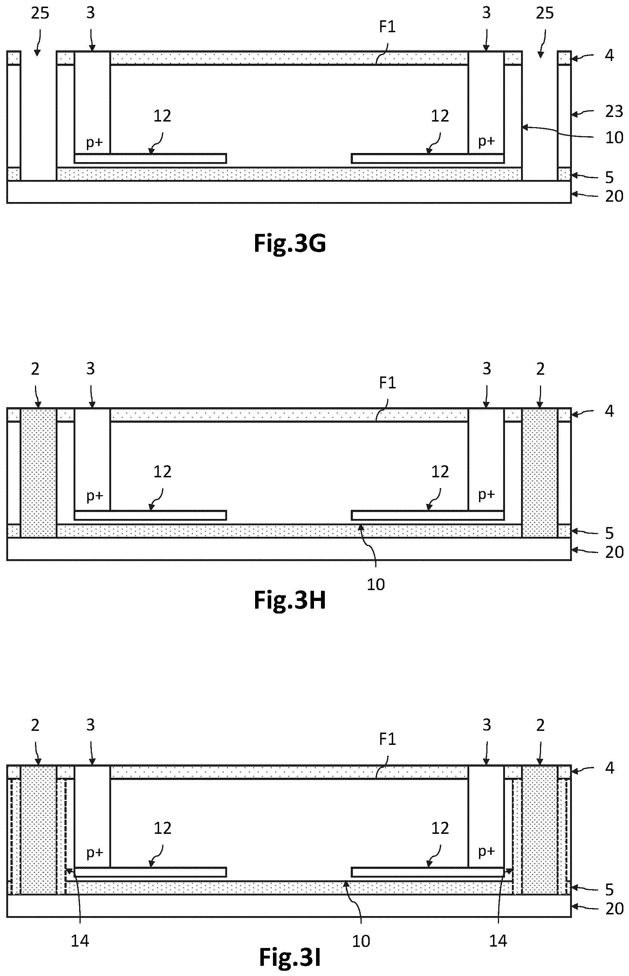

En référence à la fig.3G, on réalise ensuite une tranchée périphérique 25 dans la couche principale 23, permettant de pixelliser les démodulateurs 1 par les portions latérales périphériques 2. On réalise ainsi une gravure localisée de la couche principale 23 pour déboucher ici sur la couche 20 d'oxyde BOX. Chaque tranchée 25 s'étend ici continûment dans le plan XY autour d'une portion de détection 10. On obtient ainsi une pluralité de portions de détection 10 séparées les unes des autres par une tranchée continue 25. Elles sont obtenues de préférence par une technique de gravure anisotrope, de manière à obtenir une bordure latérale sensiblement verticale suivant l'axe Z. Les tranchées 25 présentent une dimension transversale (largeur) dans le plan XY pouvant être comprise entre $0.5\mu$m et $2\mu$m, par exemple égale à $1\mu$m. Les portions de détection 10 peuvent ainsi présenter une forme dans le plan XY par exemple circulaire, ovale, polygonale, par exemple carrée, ou toute autre forme.

En référence à la fig.3H, on réalise la portion latérale périphérique 2, par épitaxie dans les tranchées 25 d'un matériau semiconducteur cristallin ici à base de silicium, à une température comprise entre 500°C et 700°C. Il s'agit ici de silicium polycristallin. Il peut être dopé de type p, par exemple au bore avec un niveau de dopage de l'ordre de $4\times10^{19}$ cm$^{-3}$. Ce matériau présente un coefficient de dilatation thermique inférieur à celui du germanium de la portion de détection 10, de sorte qu'au retour à la température ambiante (après l'épitaxie du polysilicium dans la tranchée périphérique 25), la portion de détection 10 présente des contraintes mécaniques en tension horizontale et en compression verticale.

En référence à la fig.3I, un recuit d'interdiffusion est effectué pour former la zone latérale 14 à base de SiGe. Enfin, une étape de polissage mécanochimique (CMP) est ensuite effectuée, avec arrêt sur la face supérieure de la couche diélectrique de passivation 4, pour éliminer le matériau à base de silicium en excès et planariser la face supérieure de l'empilement.

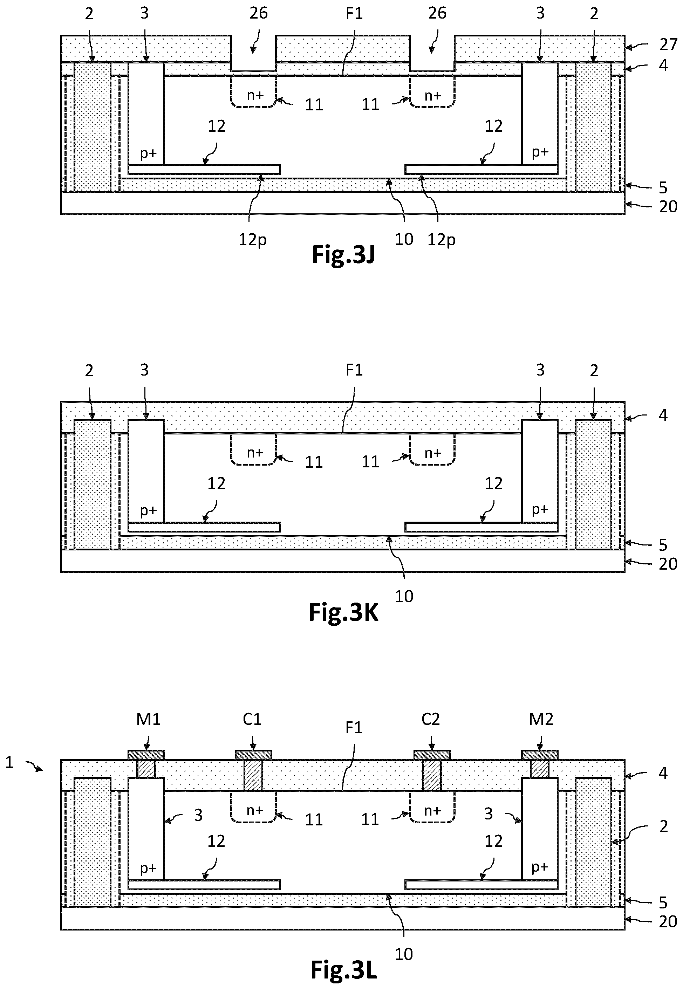

En référence à la fig.3J, on réalise des échancrures non traversantes 26 dans la couche diélectrique de passivation 4, laissant une partie non gravée par exemple de 20nm. On dépose ensuite une résine 27 (masque d'implantation), laissant libres les zones d'implantation définies par les échancrures 26. Ensuite, on réalise les régions dopées supérieures 11, ici dopées n+, par implantation ionique de phosphore (ou même avec de l'arsénique ou antimoine) dans la portion de détection 10. Le niveau de dopage peut être de l'ordre de $5\times10^{18}$ à $10^{20}$ cm$^{-3}$. Les régions dopées supérieures 11 affleurent donc la face supérieure F1 et sont situées au-dessus des régions dopées inférieures 12. Ici, elles sont situées à la perpendiculaire des extrémités proximales 12p des régions dopées inférieures 12. On retire ensuite la résine 27, et on effectue un recuit d'activation du phosphore.

Notons que les régions dopées supérieures 11 peuvent également être réalisées par reprise d'épitaxie de germanium dans des échancrures pratiquées dans la portion de détection 10 à partir de la face F1, avec dopage de type n à la croissance. Cependant, l'implantation ionique est préférée de manière à préserver les contraintes mécaniques présentes dans la portion de détection 10.

En référence à la fig.3K, on dépose une nouvelle couche diélectrique sur la couche diélectrique 4 sous-jacente, de manière à recouvrir la portion de détection 10, les vias conducteurs 3 et la portion latérale périphérique 2.

En référence à la fig.3L, on réalise les électrodes de modulation M1 et M2 qui s'étendent au travers de la couche diélectrique de passivation 4 et viennent au contact des vias conducteurs 3, ainsi que les électrodes de collection C1 et C2 qui s'étendent au travers de la couche diélectrique de passivation 4 et viennent au contact des régions dopées supérieures 11.

On obtient ainsi une matrice de démodulateurs photoniques 1 assistés par courant, ici en configuration planaire, qui est adaptée à détecter dans le proche infrarouge avec une longueur d'onde de coupure supérieure à 1.55$\mu$m, et qui présente un courant d'obscurité entre la région dopée de modulation et la région dopée de collection adjacente, du fait de leur agencement vertical et des contraintes mécaniques en compression verticale.

Des modes de réalisation particuliers viennent d'être décrits. Différentes variantes et modifications apparaîtront à l'homme du métier.

## Revendications

**1.** Démodulateur photonique (1) assisté par courant, adapté à détecter un rayonnement lumineux d'intérêt, comportant :

○ une portion de détection (10), présentant une première face (F1) et une deuxième face (F2) opposées l'une à l'autre et parallèles à un plan principal, et comportant une zone centrale (Zc) de détection du rayonnement lumineux incident,

• réalisée en un premier matériau semiconducteur cristallin à base de germanium,
• comportant des régions dopées, dont :

- au moins deux régions dopées de modulation, dopées de type p, et destinées à générer et à moduler un courant de dérive dans la portion de détection (10) ;
- au moins une région dopée de collection, dopée de type n, et destinée à collecter les porteurs de charge minoritaires photogénérés lors de l'absorption du rayonnement lumineux d'intérêt ;

○ une couche diélectrique de passivation (4), réalisée à base d'un matériau électriquement isolant, et recouvrant la première face (F1) ;
○ des électrodes (M1, M2, C1, C2), situées au niveau de la première face (F1) et traversant la couche diélectrique de passivation (4), dont des électrodes de modulation (M1, M2) en contact électrique avec les régions dopées de modulation ; et au moins une électrode de collection (C1, C2) en contact électrique avec au moins la région dopée de collection ;
○ **caractérisé en ce qu'**il comporte une portion latérale périphérique (2), entourant la portion de détection (10) dans le plan principal,

• réalisée à base d'un deuxième matériau présentant un coefficient de dilatation thermique inférieur à celui du premier matériau, la portion de détection (10) présentant alors des contraintes mécaniques en tension dans le plan principal et des contraintes mécaniques en compression suivant un axe vertical orthogonal au plan principal ;

○ et **en ce que**, lesdites régions dopées sont disposées selon un agencement vertical tel que :

• au moins une région dopée selon un premier type de conductivité, dite région dopée supérieure (11), affleure la première face (F1) et est située à proximité de la zone centrale (Zc) ;
• au moins deux régions dopées selon un deuxième type de conductivité opposé au premier type, dites régions dopées inférieures (12), sont situées à distance suivant l'axe vertical de la région dopée supérieure (11).

**2.** Démodulateur photonique (1) selon la revendication 1, dans lequel chaque région dopée inférieure (12) s'étend parallèlement au plan principal en direction de la zone centrale (Zc) et de la région dopée supérieure (11), et présente une extrémité distale (12d) éloignée de la zone centrale (Zc) et une extrémité proximale (12p) orientée vers la zone centrale (Zc).

**3.** Démodulateur photonique (1) selon la revendication 1 ou 2, comportant des vias conducteurs (3) s'étendant suivant l'axe vertical de la première face (F1) et en contact électrique avec les régions dopées inférieures (12).

**4.** Démodulateur photonique (1) selon la revendication 3, dans lequel les vias conducteurs (3) sont distincts de la portion latérale périphérique (2) ; ou les vias conducteurs (3) sont des parties, distinctes entre elles, de la portion latérale périphérique (2), celle-ci étant alors réalisée en un matériau électriquement conducteur.

5. Démodulateur photonique (1) selon l'une quelconque des revendications 3 à 4, dans lequel le ou les électrodes au contact de la ou des régions dopées supérieures (11) sont plus proches de la zone centrale (Zc) que les électrodes au contact des vias conducteurs (3).

6. Démodulateur photonique (1) selon l'une quelconque des revendications 1 à 5, comportant deux régions dopées inférieures (12) de modulation, et comportant une seule région dopée supérieure (11) de collection, située dans la zone centrale (Zc) et à distance, dans le plan principal, des régions dopées inférieures (12) de modulation.

7. Démodulateur photonique (1) selon l'une quelconque des revendications 1 à 5, comportant deux régions dopées supérieures (11), chacune étant située à la perpendiculaire de l'une des régions dopées inférieures (12).

8. Démodulateur photonique (1) selon l'une quelconque des revendications 1 à 7, dans lequel, pour une région dopée supérieure (11) et une région dopée inférieure (12) verticalement adjacente, une distance verticale, suivant l'axe vertical, entre lesdites régions dopées (11, 12) est inférieure à une distance horizontale, dans le plan principal, entre l'électrode connectée à la région dopée supérieure (11) et l'électrode connectée au via conducteur (3) de la région dopée inférieure (12) adjacente.

9. Démodulateur photonique (1) selon l'une quelconque des revendications 1 à 8, dans lequel la ou les régions dopées supérieures (11) sont des régions de collection, et les régions dopées inférieures (12) sont des régions de modulation.

10. Démodulateur photonique (1) selon l'une quelconque des revendications 1 à 9, dans lequel la portion latérale périphérique (2) est réalisée à base de silicium, et dans lequel la portion de détection (10) comporte une zone latérale (14) réalisée à base de SiGe, située à l'interface avec la portion latérale périphérique (2).

11. Démodulateur photonique (1) selon l'une quelconque des revendications 1 à 10, dans lequel les régions dopées inférieures (12) sont plus proches de la deuxième face (F2) que de la première face (F1).

12. Procédé de fabrication d'un démodulateur photonique (1) selon l'une quelconque des revendications précédentes, comportant les étapes suivantes :

   ◦ réalisation, par épitaxie à partir d'un couche support (5), d'une première couche (22) à base de germanium dopé ;
   ◦ réalisation des régions dopées inférieures (12) par gravure localisée de la première couche (22) à base de germanium dopé ;
   ◦ réalisation par épitaxie d'une couche principale (23) à base de germanium non intentionnellement dopé, sur et au contact des régions dopées inférieures (12) ;
   ◦ réalisation d'une tranchée (25) au travers de la couche principale (23) entourant la portion de détection (10) ;
   ◦ réalisation de la portion latérale périphérique (2) dans la tranchée (25), à une température supérieure à la température ambiante, de sorte que, après retour à la température ambiante, la portion de détection (10) est en tension dans le plan principal et en compression suivant l'axe vertical ;
   ◦ réalisation d'une ou des régions dopées supérieures (11) dans la portion de détection (10) ;
   ◦ dépôt d'une couche diélectrique de passivation (4) sur la portion de détection (10) ;
   ◦ réalisation des électrodes de modulation et des électrodes de collection.

13. Procédé de fabrication selon la revendication 12, comportant, avant la réalisation de la tranchée (25), une étape de réalisation de deux premières échancrures (24) débouchant sur les régions dopées inférieures (12), suivie d'une étape de réalisation de vias conducteurs (3) dans les premières échancrures (24).

14. Procédé de fabrication selon la revendication 12, tel que, lors de la réalisation de la tranchée (25), celle-ci débouche sur les régions dopées inférieures (12), de sorte que la portion latérale périphérique (2) est alors au contact de celles-ci.

15. Procédé de fabrication selon l'une quelconque des revendications 12 à 14, dans lequel la ou les régions dopées supérieures (11) sont réalisées par implantation ionique localisée.

**Patentansprüche**

1. Stromunterstützter Photonendemodulator (1), geeignet zur Erfassung einer relevanten Lichtstrahlung, umfassend:

   ○ einen Erfassungsabschnitt (10), der eine erste Seite (F1) und eine zweite Seite (F2) aufweist, die sich gegenüberstehen und parallel zu einer Hauptebene sind, und eine zentrale Zone (Zc) zur Erfassung der einfallenden Lichtstrahlung umfasst,

   • hergestellt aus einem ersten kristallinen halbleitenden Material auf Basis von Germanium,
   • umfassend dotierte Bereiche, darunter:

   - mindestens zwei modulationsdotierte, p-dotierte Bereiche, die dazu bestimmt sind, einen Driftstrom im Erfassungsabschnitt (10) zu erzeugen und zu modulieren;
   - mindestens einen n-dotierten Sammelbereich, der dazu bestimmt ist, die bei der Absorption der relevanten Lichtstrahlung photogen erzeugten Minoritätsladungsträger zu sammeln;

   ○ eine dielektrische Passivierungsschicht (4), die auf der Basis eines elektrisch isolierenden Materials hergestellt ist und die erste Seite (F1) bedeckt;
   ○ Elektroden (M1, M2, C1, C2), die sich auf der ersten Seite (F1) befinden und die dielektrische Passivierungsschicht (4) durchqueren, darunter Modulationselektroden (M1, M2), die in elektrischem Kontakt mit den modulationsdotierten Bereichen stehen; und mindestens eine Sammelelektrode (C1, C2), die in elektrischem Kontakt mit mindestens dem dotierten Sammelbereich steht;
   ○ **dadurch gekennzeichnet, dass** er einen peripheren seitlichen Abschnitt (2) umfasst, der den Erfassungsabschnitt (10) in der Hauptebene umgibt,

   • die auf der Basis eines zweiten Materials mit einem geringeren thermischen Ausdehnungskoeffizienten als das erste Material hergestellt wird, wobei der Erfassungsabschnitt (10) dann mechanische Spannungen in der Hauptebene und mechanische Druckspannungen entlang einer vertikalen Achse orthogonal zur Hauptebene aufweist;

   ○ und, dass die dotierten Bereiche in einer vertikalen Anordnung wie folgt angeordnet sind:

   • mindestens ein nach einem ersten Leitfähigkeitstyp dotierter Bereich, der als oberer dotierter Bereich (11) bezeichnet wird, bündig mit der ersten Seite (F1) ist und sich in der Nähe der zentralen Zone (Zc) befindet;
   • mindestens zwei nach einem zweiten Leitfähigkeitstyp gegenüber dem ersten Typ dotierte Bereiche, untere dotierte Bereiche (12), befinden sich in einem Abstand entlang der vertikalen Achse des oberen dotierten Bereichs (11).

2. Photonendemodulator (1) nach Anspruch 1, wobei sich jeder untere dotierte Bereich (12) parallel zur Hauptebene in Richtung des zentralen Bereichs (Zc) und des oberen dotierten Bereichs (11) erstreckt und ein distales Ende (12d) entfernt vom zentralen Bereich (Zc) und ein proximales Ende (12p) in Richtung des zentralen Bereichs (Zc) aufweist.

3. Photonendemodulator (1) nach Anspruch 1 oder 2, umfassend leitende Vias (3), die sich entlang der vertikalen Achse der ersten Seite (F1) erstrecken und in elektrischem Kontakt mit den unteren dotierten Bereichen (12) stehen.

4. Photonendemodulator (1) nach Anspruch 3, wobei die leitenden Vias (3) vom peripheren seitlichen Abschnitt (2) getrennt sind; oder die leitenden Vias (3) voneinander getrennte Teile des peripheren seitlichen Abschnitts (2) sind, wobei dieser dann aus einem elektrisch leitenden Material hergestellt ist.

5. Photonendemodulator (1) nach einem der Ansprüche 3 bis 4, wobei die Elektrode(n) in Kontakt mit dem/den oberen dotierten Bereich(en) (11) näher an der zentralen Zone (Zc) sind als die Elektroden in Kontakt mit den leitenden Vias (3).

6. Photonendemodulator (1) nach einem der Ansprüche 1 bis 5, umfassend zwei untere dotierte Modulationsbereiche (12), und umfassend einen einzigen oberen dotierten Sammlerbereich (11), der sich in der zentralen Zone (Zc) und in der Hauptebene entfernt von den unteren dotierten Modulationsbereichen (12) befindet.

7. Photonendemodulator (1) nach einem der Ansprüche 1 bis 5, umfassend zwei obere dotierte Bereiche (11), die jeweils senkrecht zu einem der unteren dotierten Bereiche (12) liegen.

8. Photonendemodulator (1) nach einem der Ansprüche 1 bis 7, wobei für einen vertikal benachbarten oberen dotierten Bereich (11) und einen vertikal benachbarten unteren dotierten Bereich (12) ein vertikaler Abstand, entlang der vertikalen Achse zwischen den dotierten Bereichen (11, 12) kleiner als ein horizontaler Abstand in der Hauptebene ist, zwischen der Elektrode, die mit dem oberen dotierten Bereich (11) verbunden ist, und der Elektrode, die mit dem Leiter (3) des benachbarten unteren dotierten Bereichs (12) verbunden ist.

9. Photonendemodulator (1) nach einem der Ansprüche 1 bis 8, wobei der/die obere(n) dotierte(n) Bereich(e) (11) Sammelbereiche und die untere(n) dotierte(n) Bereich(e) (12) Modulationsbereiche sind.

10. Photonendemodulator (1) nach einem der Ansprüche 1 bis 9, wobei der periphere seitliche Abschnitt (2) auf Siliziumbasis ausgeführt ist und wobei der Erfassungsabschnitt (10) eine seitliche Zone (14) auf SiGe-Basis umfasst, der sich an der Schnittstelle zum peripheren seitlichen Abschnitt (2) befindet.

11. Photonendemodulator (1) nach einem der Ansprüche 1 bis 10, wobei die unteren dotierten Bereiche (12) näher an der zweiten Seite (F2) als an der ersten Seite (F1) liegen.

12. Fertigungsverfahren eines Photonendemodulators (1) nach einem der vorhergehenden Ansprüche, das folgende Schritte umfasst:

○ Herstellung, durch Epitaxie aus einer Trägerschicht (5), einer ersten Schicht (22) auf Basis von dotiertem Germanium;
○ Herstellung der unteren dotierten Bereiche (12) durch lokalisierte Ätzen der ersten Schicht (22) auf Basis von dotiertem Germanium;
○ Herstellung durch Epitaxie einer Hauptschicht (23) auf Basis von nicht absichtlich dotiertem Germanium auf und in Kontakt mit den unteren dotierten Bereichen (12);
○ Herstellung eines Grabens (25) durch die Hauptschicht (23), die den Erfassungsabschnitt (10) umgibt;
○ Herstellung des peripheren seitlichen Abschnitts (2) im Graben (25) bei einer Temperatur, die über der Umgebungstemperatur liegt, so dass der Erfassungsabschnitt (10) nach Rückkehr zur Umgebungstemperatur in der Hauptebene gespannt und entlang der vertikalen Achse komprimiert ist;
○ Herstellung eines oder mehrerer oberer dotierter Bereiche (11) in dem Erfassungsabschnitt (10);
○ Ablagerung einer dielektrischen Passivierungsschicht (4) auf dem Erfassungsabschnitt (10);
○ Herstellung von Modulationselektroden und Sammelelektroden.

13. Fertigungsverfahren nach Anspruch 12, umfassend vor der Herstellung des Grabens (25) einen Schritt zur Herstellung von zwei ersten Aussparungen (24), die auf die unteren dotierten Bereiche (12) münden, gefolgt von einem Schritt zur Herstellung von leitenden Vias (3) in den ersten Aussparungen (24).

14. Fertigungsverfahren nach Anspruch 12, so dass dieser bei der Herstellung des Grabens (25) auf die unteren dotierten Bereiche (12) mündet, so dass der periphere seitliche Abschnitt (2) diese dann berührt.

15. Fertigungsverfahren nach einem der Ansprüche 12 bis 14, wobei der/die obere(n) dotierte(n) Bereich(e) (11) durch lokalisierte Ionenimplantation hergestellt wird/werden.

**Claims**

1. Current-assisted photonic demodulator (1) adapted to detect a light radiation of interest, comprising:

○ a detection portion (10), having a first face (F1) and a second face (F2) opposite one another and parallel with a main plane, and comprising a central zone (Zc) for detecting the incident light radiation,

• made of a first crystalline semiconductor material based on germanium,
• comprising doped regions, of which:

- at least two p-doped modulation regions, intended to generate and modulate a drift current in the detection portion (10);

- at least one n-doped collection region, intended to collect the minority charge carriers photogenerated during the absorption of the light radiation of interest;

○ a dielectric passivation layer (4), produced based on an electrically insulating material, and covering the first face (F1);

○ electrodes (M1, M2, C1, C2), located at the first face (F1) and passing through the dielectric passivation layer (4), of which modulation electrodes (M1, M2) in electrical contact with the doped modulation regions; and at least one collection electrode (C1, C2) in electrical contact with at least the doped collection region;

○ **characterised in that** it includes a peripheral lateral portion (2), surrounding the detection portion (10) in the main plane,

• produced based on a second material having a coefficient of thermal expansion less than that of the first material, the detection portion (10) then having tensile mechanical stress in the main plane and compressive mechanical stress along a vertical axis orthogonal to the main plane;

○ and **in that**, said doped regions are disposed according to a vertical arrangement such that:

• at least one region doped according to a first type of conductivity, referred to as upper doped region (11), is flush with the first face (F1) and is located in the vicinity of the central zone (Zc);

• at least two regions doped according to a second type of conductivity opposite the first type, referred to as lower doped regions (12), are located at a distance along the vertical axis from the upper doped region (11).

2. Photonic demodulator (1) according to claim 1, wherein each lower doped region (12) extends parallel with the main plane towards the central zone (Zc) and the upper doped region (11), and has a distal end (12d) distant from the central zone (Zc) and a proximal end (12p) oriented towards the central zone (Zc).

3. Photonic demodulator (1) according to claim 1 or 2, comprising conductive vias (3) extending along the vertical axis of the first face (F1) and in electrical contact with the lower doped regions (12).

4. Photonic demodulator (1) according to claim 3, wherein the conductive vias (3) are distinct from the peripheral lateral portion (2); or the conductive vias (3) are parts, mutually distinct, of the peripheral lateral portion (2), the latter then being made of an electrically conductive material.

5. Photonic demodulator (1) according to any one of claims 3 to 4, wherein the electrode(s) in contact with the upper doped region(s) (11) are closer to the central zone (Zc) than the electrodes in contact with the conductive vias (3).

6. Photonic demodulator (1) according to any one of claims 1 to 5, comprising two lower doped modulation regions (12), and comprising a single upper doped collection region (11), located in the central zone (Zc) and at a distance, in the main plane, from the lower doped modulation regions (12).

7. Photonic demodulator (1) according to any one of claims 1 to 5, comprising two upper doped regions (11), each being located perpendicular to one of the lower doped regions (12).

8. Photonic demodulator (1) according to any one of claims 1 to 7, wherein, for an upper doped region (11) and a vertically adjacent lower doped region (12), a vertical distance, along the vertical axis, between said doped regions (11, 12) is less than a horizontal distance, in the main plane, between the electrode connected to the upper doped region (11) and the electrode connected to the conductive via (3) of the adjacent lower doped region (12).

9. Photonic demodulator (1) according to any one of claims 1 to 8, wherein the upper doped region(s) (11) are collection regions, and the lower doped regions (12) are modulation regions.

10. Photonic demodulator (1) according to any one of claims 1 to 9, wherein the peripheral lateral portion (2) is produced based on silicon, and wherein the detection portion (10) includes a lateral zone (14) produced based on SiGe, located at the interface with the peripheral lateral portion (2).

11. Photonic demodulator (1) according to any one of claims 1 to 10, wherein the lower doped regions (12) are closer to the second face (F2) than the first face (F1).

12. Method for manufacturing a photonic demodulator (1) according to any one of the preceding claims, comprising the following steps:

- producing, by epitaxy from a support layer (5), a first layer (22) based on doped germanium;
- producing the lower doped regions (12) by localised etching of the first layer (22) based on doped germanium;
- producing by epitaxy a main layer (23) based on unintentionally doped germanium, on and in contact with the lower doped regions (12);
- producing a trench (25) through the main layer (23) surrounding the detection portion (10);
- producing the peripheral lateral portion (2) in the trench (25), at a temperature greater than ambient temperature, such that, after returning to ambient temperature, the detection portion (10) is tensile in the main plane and compressive along the vertical axis;
- producing one or more upper doped regions (11) in the detection portion (10);
- depositing a dielectric passivation layer (4) on the detection portion (10);
- producing the modulation electrodes and the collection electrodes.

13. Manufacturing method according to claim 12, comprising, before producing the trench (25), a step of producing two first notches (24) opening onto the lower doped regions (12), followed by a step of producing conductive vias (3) in the first notches (24).

14. Manufacturing method according to claim 12, such that, when producing the trench (25), it opens onto the lower doped regions (12), in such a way that the peripheral lateral portion (2) is then in contact with them.

15. Manufacturing method according to any one of claims 12 to 14, wherein the upper doped region(s) (11) are produced by localised ion implantation.

**Fig.1A**

**Fig.1B**

**Fig.1C**

**Fig.2A**

**Fig.2B**

**Fig.2C**

**Fig.3A**

22
21
5
20

**Fig.3B**

12    12p    12    12d

21
5
20

F1

12    12    23

21
5
20

F2

**Fig.3C**

**Fig.3D**

**Fig.3E**

**Fig.3F**

**Fig.3G**

**Fig.3H**

**Fig.3I**

## Fig.3J

## Fig.3K

## Fig.3L

# EP 4 386 873 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2022123985 A1

**Littérature non-brevet citée dans la description**

- **VAN NIEUWENHOVE et al.** Novel Standard CMOS Detector using Majority Current for giding Photo-Generated Electrons towards Detecting Junctions. *Proc. Symp. IEEE/LEOS Benelux*, 2005, 229-232

- **DALLA BETTA et al.** Design and Characterization of Current-Assisted Photonic Demodulators in 0.18-$\mu$m CMOS Technology. *IEEE Trans. Electron Devices*, June 2011, vol. 58 (6), 1702-1707
- **HARTMANN ; AUBIN**. Assessment of the growth/etch back technique for the production of Ge strain-relaxed buffers on Si. *Journal of Crystal Growth*, 2018, vol. 488, 43